# EUROPEAN PATENT SPECIFICATION

(11) **EP 4 060 853 B1**
(45) Date of publication and mention of the grant of the patent: **28.08.2024**
(21) Application number: 19952565.0
(22) Date of filing: 11.11.2019
(51) Int. Cl.: H02J 7/00, H01M 10/44, H02J 7/02, H01M 10/48

(54) **ELECTRONIC DEVICE AND CHARGING CONTROL METHOD OF ELECTRONIC DEVICE**
ELEKTRONISCHE VORRICHTUNG UND LADESTEUERUNGSVERFAHREN DER ELEKTRONISCHEN VORRICHTUNG
DISPOSITIF ÉLECTRONIQUE ET PROCÉDÉ DE COMMANDE DE CHARGE DE DISPOSITIF ÉLECTRONIQUE

(43) Date of publication of application: 21.09.2022
(73) Proprietor: LG Electronics Inc., SEOUL 07336 (KR)
(72) Inventor: KIM, Seung Yon, Seoul 06772 (KR); LIM, Gi Hong, Seoul 06772 (KR); KIM, Jeong Woo, Seoul 06772 (KR); HONG, Seok Min, Seoul 06772 (KR); MOON, Hee Joon, Seoul 06772 (KR); KANG, Hye Yeong, Seoul 06772 (KR)
(74) Representative: Frenkel, Matthias Alexander
(86) International application number: PCT/KR2019/015287
(87) International publication number: WO 2021/095895

(56) References cited:
- WO-A1-2013/008396
- JP-A- 2003 087 991
- JP-A- 2012 115 004
- KR-A- 20010 043 673
- KR-A- 20110 132 977
- KR-A- 20190 026 424
- US-A1- 2007 222 419
- US-A1- 2008 278 111
- US-A1- 2011 279 092
- US-A1- 2018 123 369

## Description

### Technical Field

The present invention relates to an electronic device and a charging control method of the electronic device.

### Background Art

Recently, with developments of digital technologies, various types of electronic devices such as a mobile communication terminal, a smartphone, a tablet personal computer (PC), a notebook, a personal digital assistant (PDA), a wearable device, or a digital camera are widely used.

Meanwhile, as more functions are provided by such electronic devices, interest in technology for charging a battery for supplying power to an electronic device has increased.

US 2011/279092 A1 discloses a method of receiving a temperature indication, the temperature indication being a function of a temperature of a power pack of a portable electronic device; determining, as a function of the temperature indication, whether the temperature is within an elevated operating temperature range; and reducing a charge termination voltage and a charging current when the temperature is within the elevated operating temperature range. The method includes increasing the termination current when charging the power pack is performed above the normal operating temperature and within the elevated operating temperature range 40 ° C to 60 ° C.

WO 2013/008396 A1 discloses a method of setting the charge termination current value in accordance with the temperature of the battery.

US 2008/278111 A1 discloses a method for charging a power storage element from a generator comprises temperature measurement, with switching from a first charging mode to a second charging mode in which the voltage is regulated by the temperature. The first charging mode is charging at regulated current to a maximum current value which is a function of the state of charge of the power storage element and of the temperature of the power storage element. Switching is performed when the voltage at the terminals of the power storage element reaches a preset threshold value, itself a function of the value of the current and temperature of the power storage element.

US 2018/123369 A1 discloses a method for charging a battery (102) comprises obtaining, by charging circuitry, an open circuitry voltage of the battery prior to a charging session. The charging circuitry is in electrical communication with a power source and the battery. The method also comprises initiating the charging session to charge the battery at a constant charge current-constant charge voltage with power provided from the power source and obtaining an ambient temperature measured by a temperature sensor in communication with the charging circuitry. The method also comprises obtaining a charge termination time based on the ambient temperature and terminating the charging session when the charge termination time is reached.

US 2007/222419 A1 discloses a method of determining a temperature associated with the battery; identifying a cutoff parameter based on the determined temperature; determining when the supplied current matches a value corresponding to the cutoff parameter; and stopping further supply of the supplied current to the battery when the supplied current matches the value corresponding to the current cutoff parameter.

JP 2003 087991 A discloses a temperature detecting means for detecting the temperature of the battery. When the current value calculating means has a temperature detected by the temperature detecting means higher than a predetermined temperature, the charge cutoff current value is set to be larger than the charge cutoff current value at a predetermined temperature. When the temperature detected by the temperature detecting means is lower than the predetermined temperature, the charge cutoff current value is set at the predetermined temperature.

KR 2019 0026424 A discloses a wireless charging method of a wireless power transmitter wirelessly transmitting power to a wireless power receiver, comprising the steps of: receiving a charging state packet from the wireless power transmitter at every first cycle and receiving a receiving power packet at every second cycle; determining whether a charging stage value of the charging state packet is increased; determining whether a receiving power value of the receiving power packet is less than or equal to a predetermined power value; and determining the wireless power receiver to be in a first charging state when the charging state value is not increased and the receiving power value is less than or equal to the predetermined power value.

JP 2012 115004 A discloses a method of calculating a charging time of the battery based on a first charging rate, a constant-current charging rate and a second charging rate. The first charging rate is calculated in accordance with a prescribed charge termination current by using: a path resistance value of the battery calculated based on a value detected by the detection means during a constant voltage charge; a charging voltage of the battery; and an internal resistance value of the battery at present temperature. The constant-current charging rate is calculated by using the first charging rate. The second charging rate is calculated by using the first charging rate in accordance with a charge termination current unique to a charging circuit for a battery.

KR 2011 0132977 A and KR 2001 0043673 A relate to the conventional art of managing the charging of a battery pack.

### Disclosure of Invention

### Technical Goals

In an electronic device, repetitive charging and discharging of a battery may cause a swelling phenomenon of a battery pack. Accordingly, safety measures may be required to prevent a safety accident such as fire or explosion.

Various example embodiments of the present disclosure provide an electronic device and a method to efficiently control charging of a battery based on a change in temperature of the battery.

### Technical solutions

According to the present invention, an electronic device and a charging control method are set forth in independent claims. Preferred embodiments are provided in the dependent claims. According to an aspect, there is provided an electronic device including a battery, a charging module configured to charge the battery, at least one sensor, and a controller. The controller is configured to acquire state information of the battery using the at least one sensor, determine a charging condition of the battery based on the state information of the battery, and control the charging module to charge the battery based on the charging condition.

The controller is configured to determine an end of charge (EoC) current of the battery based on the state information of the battery and control the charging module to charge the battery based on the determined EoC current.

The controller is configured to acquire temperature information of the battery using the at least one sensor and determine a charging condition of the battery based on the temperature information of the battery.

The controller is configured to charge the battery using the charging module when a temperature of the battery is within a predetermined range and suspend charging of the battery when the temperature of the battery is out of the predetermined range.

In a case in which the temperature of the battery is within the predetermined range, the controller may be configured to determine an EoC current of the battery to be a first current value when the temperature of the battery is less than or equal to a first designated value, and determine the EoC current of the battery to be a second current value greater than the first current value when the temperature of the battery is greater than the first designated value.

In the case in which in which the temperature of the battery is within the predetermined range, the controller may be configured to determine the EoC current of the battery to be the second current value when the temperature of the battery is greater than the first designated value and less than or equal to the second designated value, and determine the EoC current of the battery to be a third current value greater than the second current value when the temperature of the battery is greater than the second designated value.

The controller may be configured to detect a magnitude of a current supplied to the battery using the at least one sensor and control the charging module to terminate charging of the battery when the magnitude of the current supplied to the battery is less than or equal to the EoC current.

The controller may be configured to periodically update the state information of the battery using the at least one sensor and re-determine a charging condition of the battery based on the updated state information of the battery.

The controller may be configured to acquire temperature information of the battery using the at least one sensor, determine an EoC current of the battery to be a first current value when a temperature of the battery corresponds to a first temperature section, and determine the EoC current of the battery to be a second current value greater than the first current value when the temperature of the battery corresponds to a second temperature section higher than the first temperature section.

The at least one sensor may include a current sensor.

The controller may be configured to charge the battery using a wireless charging module or a wired charging module included in the charging module.

According to another aspect, there is also provided a charging control method of an electronic device, the method including acquiring state information of a battery using at least one sensor, determining a charging condition of the battery based on the state information of the battery, and charging the battery based on the charging condition.

The state information of the battery includes temperature information of the battery. The determining of the charging condition of the battery includes determining an EoC current of the battery based on the temperature information of the battery.

The determining of the EoC may include determining the EoC current of the battery to be a first current value when a temperature of the battery corresponds to a first temperature range, and determining the EoC current of the battery to be a second current value greater than the first current value when the temperature of the battery corresponds to a second temperature range higher than the first temperature range.

The state information of the battery may further include the magnitude of the current supplied to the battery. The charging control method may further include terminating charging of the battery when a magnitude of a current supplied to the battery reaches the determined EoC current.

### Effects

According to example embodiments, it is possible to provide an electronic device that prevents an overcharging of a battery and a cell damage of the battery, thereby maximizing a battery life of the electronic device.

Further, it is possible to improve a safety and a reliability of an electronic device by minimizing a battery swelling phenomenon and provide an efficient battery charging function.

### Brief Description of Drawings

FIG. 1 is a block diagram illustrating an electronic device according to various embodiments.
FIG. 2 is a block diagram illustrating an electronic device according to an example embodiment of the present disclosure.
FIG. 3 is a flowchart illustrating a charging control method of an electronic device according to an example embodiment of the present disclosure, not covered by the appended claims.
FIG. 4 is a flowchart illustrating a charging control method of an electronic device according to an example embodiment of the present disclosure, not covered by the appended claims.
FIG. 5 is a flowchart illustrating a charging control method of an electronic device according to an example embodiment of the present disclosure.
FIG. 6 is a diagram illustrating an end of charge (EoC) current based on a temperature of a battery of an electronic device according to an example embodiment of the present disclosure.
FIGS. 7A and 7B are graphs for explaining a battery charging situation of an electronic device according to an example embodiment of the present disclosure.

### Best Mode for Carrying Out the Invention

Hereinafter, example embodiments of the present disclosure will be described in detail with reference to the accompanying drawings, and the same or similar elements are designated with the same numeral references regardless of the numerals in the drawings and their redundant description will be omitted. A suffix "module" or "unit" used for constituent elements disclosed in the following description is merely intended for easy description of the specification, and the suffix itself does not give any special meaning or function. In describing the present disclosure, moreover, the detailed description will be omitted when a specific description for publicly known technologies to which the invention pertains is judged to obscure the gist of the present disclosure. Also, it should be noted that the accompanying drawings are merely illustrated to easily explain the concept of the invention, and therefore, they should not be construed to limit the technological concept disclosed herein by the accompanying drawings.

The terms 'first', 'second', etc. may be used to describe various components, but the components are not limited by such terms. The terms are used only for the purpose of distinguishing one component from other components.

When an arbitrary component is described as "being connected to" or "being linked to" another component, this should be understood to mean that still another component(s) may exist between them, although the arbitrary component may be directly connected to, or linked to, the corresponding other component. In contrast, when an arbitrary component is described as "being directly connected to" or "being directly linked to" another component, this should be understood to mean that no component exists between them.

A singular expression can include a plural expression as long as it does not have an apparently different meaning in context.

In the present application, the terms "include" and "have" should be understood to be intended to designate that illustrated features, numbers, steps, operations, components, parts or combinations thereof exist and not to preclude the existence of one or more different features, numbers, steps, operations, components, parts or combinations thereof, or the possibility of the addition thereof.

An electronic device according to various embodiments may include at least one of a mobile phone, a smartphone, a laptop computer, a digital broadcasting terminal, personal digital assistants (PDA), a portable multimedia player (PMP), a navigator, a slate PC, a tablet PC, an ultrabook, a wearable device (e.g., smartwatch), a smart glass, a head-mounted display (HMD), a digital TV, a desktop computer, or a digital signage.

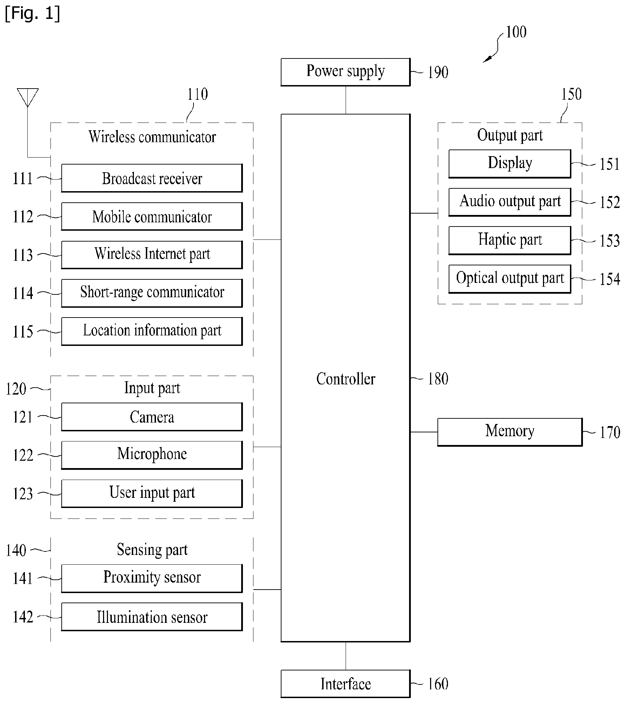

FIG. 1 is a block diagram illustrating an electronic device according to various embodiments.

Referring to FIG. 1, an electronic device 100 may include at least one of a wireless communicator 110, an input part 120, a sensing part 140, an output part 150, an interface 160, a memory 170, a controller (or processor) 180, and a power supply 190.

The electronic device 100 may include other components in addition to the components of FIG. 1 and may also include some of the components of FIG. 1.

The wireless communicator 110 may include at least one module that enables wireless communication to be performed between the electronic device 100 and a wireless communication system, between the electronic device 100 and another electronic device (not shown) (e.g., the electronic device 100), or between the electronic device 100 and an external server. The wireless communicator 110 may include one or more modules that connect the electronic device 100 to one or more networks. The wireless communicator 110 may include at least one of a broadcast receiver 111, a mobile communicator 112, a wireless internet part 113, a short-range communicator (NFC) 114, and a location information part 115.

The input part 120 may include at least one of an image input part (for example, a camera 121) that receives an image signal input, an audio input part (for example, a microphone 122) that receives an audio signal input, or a user input part 123 that receives a user input. For example, the user input part 123 may receive a user touch input through a touch sensor (or touch panel) provided in a display 151 or receive a user input through a mechanical key. Information collected in the input part 120 (for example, voice data and image data) may be analyzed and processed as a control command of a user.

The sensing part 140 may include one or more sensors to sense at least one of information in the electronic device 100, surrounding environment information of the electronic device 100, or user information.

For example, the sensing part 140 may include at least one of a proximity sensor 141, an illumination sensor 142, a touch sensor, or a finger scan sensor. In addition, the sensing part 140 may include at least one of an acceleration sensor, a magnetic sensor, a gravity (G)-sensor, a gyroscope sensor, a motion sensor, an RGB sensor, an infrared (IR) sensor, an ultrasonic sensor, an optical sensor, a battery gauge(for example, a temperature sensor 230, a current sensor 240), an environment sensor (for example, a barometer, a hygrometer, a thermometer, a radioactivity sensor, a heat sensor, and a gas detection sensor), or a chemical sensor (for example, an electronic nose, a healthcare sensor, and a biometric sensor).

In the present disclosure, the electronic device 100 may use a combination of pieces of information sensed in at least two sensors among the aforementioned sensors.

The output part 150 may output information related to visual, auditory, or tactile. For example, the output part 150 may include at least one of the display 151, an audio output part 152, a haptic part 153, or an optical output part 154.

In one example embodiment, the display 151 may form a layer structure or an integrated structure with a touch sensor to implement a touch screen that simultaneously provides a touch input function and a screen output function. For example, the touch screen may function as the user input part 123 that provides an input interface between the electronic device 100 and a user and may function as the output part 150 that provides an output interface between the electronic device 100 and the user.

The audio output part 152 may externally output audio data stored in the memory 170 or received from the wireless communicator 110 in a call signal reception, a call mode or a recording mode, a voice recognition mode, a broadcast reception mode, or the like. The audio output part 152 may output an acoustic signal associated with a function (for example, a call signal reception sound and a message reception sound) performed in the electronic device 100. For example, the audio output part 152 may include at least one of a receiver, a speaker, or a buzzer.

The haptic part 153 may generate various tactile effects to be experienced by a user. A vibration may be a representative example of the tactile effects generated by the haptic part 153. An intensity and a pattern of the vibration generated by the haptic part 153 may be determined based on a selection of a user or setting of the controller 180. For example, the haptic part 153 may output a combination of different vibrations or output different vibrations in sequence.

The optical output part 154 may output a signal to announce an event occurrence using light of a light source of the electronic device 100. For example, an event occurring in the electronic device 100 may include at least one of message reception, call signal reception, missed call, alarm, schedule notification, e-mail reception, and application-based information reception.

The interface 160 may function as a passage to various types of external devices connected to the electronic device 100. For example, the interface 160 may include at least one of a wired/wireless headset port, an external charger port, a wired/wireless data port, a memory card port, a port connecting a device equipped with an identification module, an audio input/output (I/O) port, a video I/O port, and an earphone port. In response to the interface 160 being connected to an external device, the electronic device 100 may perform a control or a function associated with the connected external device.

The memory 170 may store data related to various functions of the electronic device 100. For example, the memory 170 may store application programs (or applications) run in the electronic device 100, data for operation of the electronic device 100, and instructions. As an example, at least a portion of the application programs may be downloaded from an external server through wireless communication. As another example, at least a portion of the application programs may be previously stored in the memory 170 for a function (for example, call forwarding and outgoing function and message receiving and outgoing function) of the electronic device 100. The application program stored in the memory 170 may be run to perform a predetermined operation (or function) of the electronic device 100 based on the controller 180.

The controller 180 (e.g., processor) may control an overall operation of the electronic device 100. For example, the controller 180 may process a signal, data, information, and the like input or output through components of the electronic device 100 or run the application program stored in the memory 170, thereby providing information to a user or performing a predetermined function.

For example, to run the application program stored in the memory 170, the controller 180 may control at least a portion of the components of the electronic device 100 of FIG. 1. To run the application program, the controller 180 may operate a combination of two or more components among the components included in the electronic device 100.

The power supply 190 may supply power to each component included in the electronic device 100 by receiving external or internal power based on a control of the controller 180.

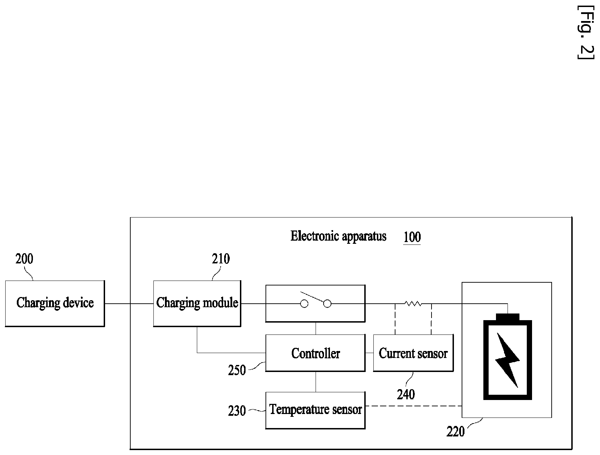

For example, the power supply 190 may receive power from a battery (e.g., a battery 220 of FIG. 2). The battery may include a built-in battery or a removable battery.

The power supply 190 may include a power regulator that adjusts a voltage level or current level of the power. The power supply 190 may adjust the power to a voltage level or current level suitable for each component of the electronic device 100 and provide the adjusted power to the corresponding component.

At least some of the above-described components of the electronic device 100 may cooperate with one another to implement an operation, a control, or a control method of the electronic device 100 described herein. Also, the operation, the control, or the control method of the electronic device 100 may be implemented through an execution of at least one application program stored in the memory 170.

FIG. 2 is a block diagram illustrating an electronic device according to an example embodiment of the present disclosure.

Referring to FIG. 2, the electronic device 100 may include a charging module 210 and a battery 220.

The charging module 210 may charge the battery 220 with power supplied from an external charging device 200.

The charging module 210 may select a charging scheme based on at least one of a type of the charging device 200, an amount of power to be supplied from the charging device 200, or a state of the battery 220. The charging module 210 may charge the battery 220 based on the selected charging scheme. The selecting of the charging scheme may be performed under a control of a controller 250, for example.

For example, the charging module 210 may control a charging voltage or a charging current to charge the battery 220 through either a fast charging or a normal speed charging.

Also, the charging module 210 may charge the battery 220 through either a wired charging or a wireless charging based on a type of the charging device 200.

The charging module 210 may include at least one of a wired charging module or a wireless charging module. As an example, the electronic device 100 may be connected to the charging device 200 through a connecting port provided as an interface (e.g., the interface 160 of FIG. 1). The charging module 210 may charge the battery 220 using power supplied from the charging device 200 to which the charging module 210 is wired through the connecting port. As another example, the charging module 210 may wirelessly charge the battery 220 without using the connecting port. When the external charging device 200 is determined as a wireless power transmitting device, the electronic device 100 may be supplied with power using at least one of an inductive coupling scheme based on a magnetic induction phenomenon or a magnetic resonance coupling scheme based on an electromagnetic resonance phenomenon, to charge the battery 220.

The electronic device 100 may include at least one sensor, for example, a battery gauge to acquire state information of the battery 220.

The electronic device 100 may use a temperature sensor 230 and a current sensor 240 to acquire temperature information of the battery 220 and information on a current supplied to the battery 220.

The electronic device 100 may use the at least one sensor to acquire state information associated with at least one of a capacity of the battery 220, a number of charging and discharging times, overcharging, over-discharging, cell-balancing, or whether swelling occurs.

The controller 250 (e.g., the controller 180 of FIG. 1) may acquire state information of the battery 220 by controlling the at least one sensor (e.g., the temperature sensor 230 and the current sensor 240). Also, the controller 250 may control the charging module 210 to charge the battery 220.

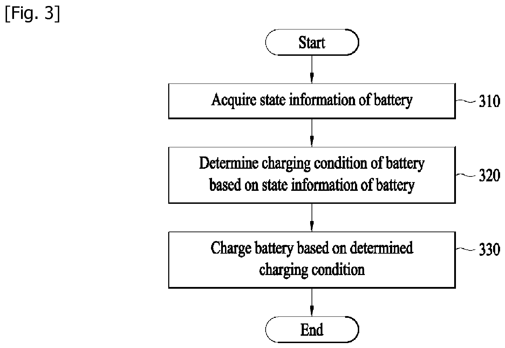

FIG. 3 is a flowchart illustrating a charging control method of an electronic device according to an example embodiment of the present disclosure, not covered by the appended claims.

Referring to FIG. 3, in operation 310, the electronic device 100 may acquire state information of the battery 220.

The controller 250 may use at least one sensor to acquire state information (e.g., temperature information of the battery 220 and charging current information of the battery 220) of the battery 220.

In operation 320, the controller 250 of the electronic device 100 may determine a charging condition related to charging of the battery 220 based on the state information of the battery 220. For example, the charging condition may include a charging current (or charging voltage) condition of the battery 220 or an end of charge (EoC) current in the charging of the battery 220.

For example, based on the state information of the battery 220, the controller 250 may determine whether the battery 220 is charged through the fast charging or the normal speed charging, or determine a reference condition to terminate the charging of the battery 220.

In operation 330, the controller 250 may control the charging module 210 to charge the battery 220 based on the charging condition determined in operation 320.

For example, the charging module 210 may adjust the power supplied from the external charging device 200 to a predetermined current level or voltage level under the control of the controller 250, to charge the battery 220. Also, the charging module 210 may terminate the charging of the battery 220 based on the charging condition determined by the controller 250.

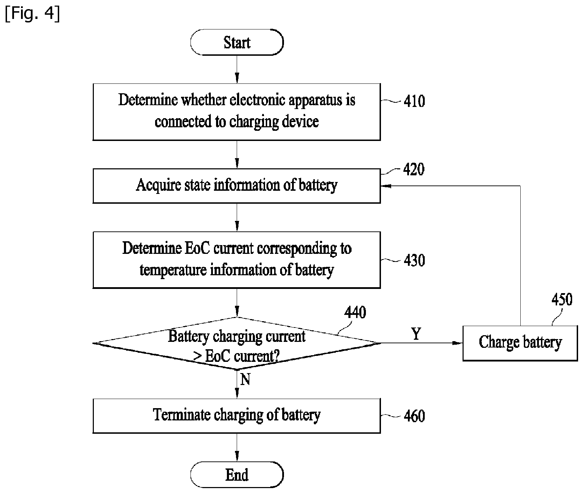

FIG. 4 is a flowchart illustrating a charging control method of an electronic device according to an example embodiment of the present disclosure, not covered by the appended claims.

Referring to FIG. 4, in operation 410, the electronic device 100 (e.g., the controller 250 of the electronic device 100) may determine whether the electronic device 100 is connected to a charging device (e.g., the charging device 200 of FIG. 2).

For example, the electronic device 100 (e.g., the controller 250) may determine whether the electronic device 100 is wired or wirelessly connected to the external charging device 200.

In this example, the electronic device 100 may identify a type of the charging device 200 and determine a charging scheme for the battery 220 based on the identified type of the charging device 200.

In operation 420, the electronic device 100 (e.g., the controller 250) may acquire state information of the battery 220 when it is determined that the electronic device 100 is connected with the charging device 200 in operation 410.

In operation 430, the electronic device 100 (e.g., the controller 250) may determine an EoC current of the battery 220 based on the state information of the battery 220.

The controller 250 may acquire temperature information of the battery 220 using at least one sensor, for example, the temperature sensor 230. The controller 250 may determine an EoC current value corresponding to the temperature information based on the acquired temperature information of the battery 220.

The EoC current of the battery 220 may be set to have a value that increases according to an increase in temperature of the battery 220.

For example, the electronic device 100 may compare a (current) temperature of the battery 220 to a threshold temperature value stored in the memory 170 and determine an EoC current of the battery 220 based on a comparison result.

When the temperature of the battery 220 is less than or equal to a first designated value, the controller 250 may determine the EoC current of the battery 220 to be a first current value. Also, when the temperature of the battery 220 is greater than the first designated value, the controller 250 may determine the EoC current of the battery 220 to be a second current value, the second current value being greater than the first current value.

When the temperature of the battery 220 is less than or equal to a second designated value, and when the temperature of the battery 220 is greater than the first designated value, the controller 250 may determine the EoC current of the battery 220 to be the second current value. When the temperature of the battery 220 is greater than the second designated value, the controller 250 may determine the EoC current to be a third current value, the third current value being greater than the second current value.

In operation 440, the electronic device 100 (e.g., the controller 250) may determine whether a magnitude of a current supplied to the battery 220, that is, a magnitude of a charging current of the battery 220 is greater than the EoC current of the battery 220, based on the state information of the battery 220.

For example, the controller 250 may acquire information on a current supplied to the battery 220 using the current sensor 240. When a magnitude of the current supplied to the battery 220 is greater than that of the EoC current, in operation 450, the controller 250 may control the charging module 210 to charge the battery 220.

When a magnitude of the current supplied to the battery 220 is less than or equal to the EoC current, in operation 460, the controller 250 may control the charging of the battery 220 to be terminated.

In operation 450, while the battery 220 is charged, the controller 250 may periodically acquire state information of the battery 220, and determine the EoC current of operation 430 again or determine whether to terminate the charging of the battery 220 based on the state information, for example, temperature information or charging current information of the battery 220.

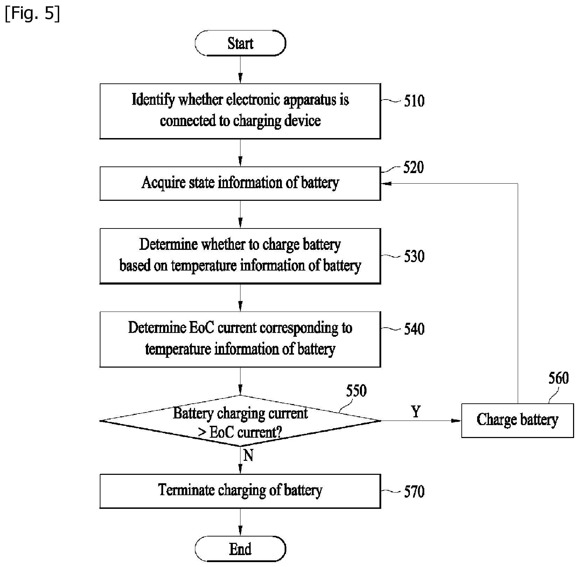

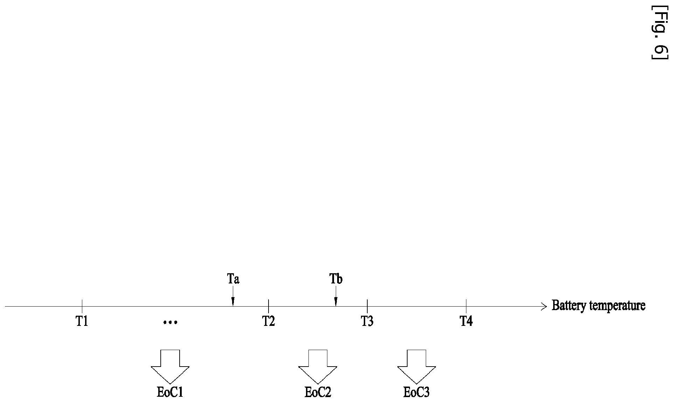

FIG. 5 is a flowchart illustrating a charging control method of an electronic device according to an example embodiment. FIG. 6 is a diagram illustrating an EoC current based on a battery temperature range of an electronic device according to an example embodiment.

Referring to FIG. 5, the electronic device 100 charges the battery 220 under a control of the controller 250.

In operation 510, the controller 250 may identify whether the electronic device 100 is connected to the external charging device 200. For example, the controller 250 may determine whether the charging device 200 is wired through a connecting port of the interface 160. Alternatively, the controller 250 may determine whether the charging device 200 is disposed adjacent to a wireless charging module to supply power.

In operation 520, when it is determined that the electronic device 100 is connected with the charging device 200, the controller 250 acquires state information of the battery 220 using at least one sensor to determine whether the battery 220 is to be charged and a charging scheme of the battery 220.

Specifically, in operation 530, the controller 250 determines whether to charge the battery 220 based on temperature information of the battery 220 acquired through the temperature sensor 230.

When a temperature of the battery 220 is within a predetermined range based on a preset criterion, the controller 250 performs a next operation for charging the battery 220 using the charging module 210. When the temperature of the battery 220 is out of the predetermined range, the controller 250 controls the battery 220 not to be charged.

Specifically, when the temperature of the battery 220 is less than a first reference temperature value (e.g., T1 of FIG. 6) or greater than a second reference temperature value (e.g., T4 of FIG. 6), the controller 250 controls the charging not to be performed to prevent overheating, swelling, or life reduction of the battery 220. When the temperature of the battery 220 is greater than or equal to the first reference temperature value and less than or equal to the second reference temperature value, in operation 540, the controller 250 determines a charging condition of the battery 220.

In operation 540, the controller 250 determines an EoC current of the battery 220 based on the temperature of the battery 220.

Specifically, the controller 250 divides the temperature range of the battery 220 into a predetermined number of sections based on a preset criterion and determines an EoC current corresponding to a section including the temperature of the battery 220 to be the EoC current of the battery 220.

When the temperature of the battery 220 corresponds to a first temperature section, the controller 250 may determine the EoC current of the battery 220 to be the first current value. When the temperature of the battery 220 corresponds to a second temperature section higher than the first temperature section, the controller 250 may determine the EoC current of the battery 220 to be the second current value greater than the first current value.

Referring to FIG. 6, the first temperature range may be greater than T1 and less than or equal to T2. Also, the second temperature range may be greater than T2 and less than or equal to T3.

For example, the temperature of the battery 220 may be measured as Ta that belongs to the first temperature range. In this example, the controller 250 may determine the EoC current of the battery 220 to be EoC1 that is an EoC current corresponding to the first temperature range.

When it is determined that the temperature of the battery 220 is Tb and within the second temperature range, the controller 250 may determine the EoC current of the battery 220 to be EoC2 that is an EoC current corresponding to the second temperature range.

Also, when the temperature of the battery 220 is within a third temperature range higher than the second temperature range, for example, when the temperature of the battery 220 is greater than T3 and less than or equal to T4, the controller 250 may determine the EoC current of the battery 220 to be EoC3 that is an EoC current corresponding to the third temperature range.

Meanwhile, like operation 530, when the temperature of the battery 220 is higher than the third temperature range (or lower than the first temperature range), for example, when the temperature of the battery 220 is greater than T4 (or less than T1), the controller 250 may not determine a separate EoC current and may control the charging of the battery 220 not to be performed.

In the electronic device 100 according to example embodiments, the temperature range and the EoC current corresponding to each temperature range are not limited to the classification method illustrated in FIG. 6. The electronic device 100 may set the charging condition of the battery 220 based on an EoC current for each temperature section of various numbers and ranges.

In operation 550, when a charging current of the battery 220 has a value greater than that of the EoC current determined in operation 540, the controller 250 may perform the charging of the battery 220 in operation 560. When the charging current of the battery 220 has a value less than or equal to that of the EoC current, the controller 250 may terminate the charging of the battery 220 in operation 570.

While the battery 220 is charged in operation 560, the controller 250 may periodically acquire state information of the battery 220.

The controller 250 may re-determine the EoC current of operation 540 or periodically determine whether the charging termination condition of operation 550 is satisfied, based on the periodically acquired state information of the battery 220.

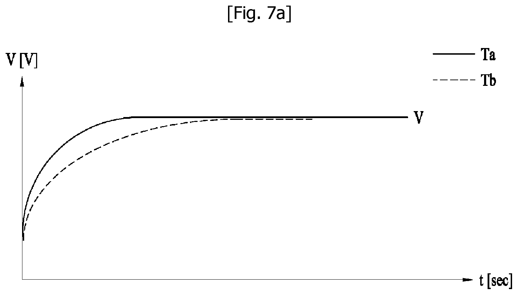

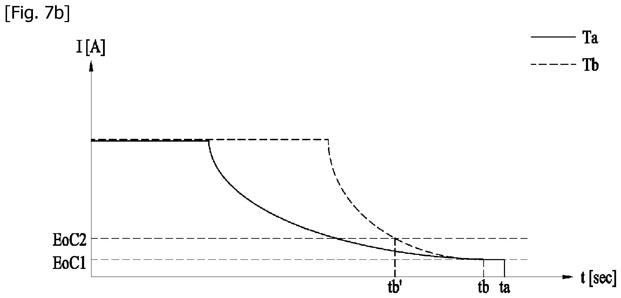

FIGS. 7A and 7B are graphs for explaining a battery charging situation of an electronic device according to an example embodiment. FIG. 7A is a graph representing a charging voltage of the battery 220 based on a charging time during charging of the battery 220 of the electronic device 100. FIG. 7B is a graph representing a charging current of the battery 220 based on the charging time during the charging of the battery 220 of the electronic device 100 of FIG. 7A.

In FIGS. 7A and 7B, charging voltage and charging current graphs obtained when a temperature of the battery 220 is Ta are indicated by solid lines and charging voltage and charging current graphs obtained when the temperature of the battery 220 is Tb higher than Ta are indicated by dashed lines.

Referring to FIGS. 7A and 7B, in the electronic device 100, the charging of the battery 220 may be performed such that a charging current is constantly maintained and a charging voltage increases with the lapse of the charging time for a predetermined time (e.g., a straight-line section of FIG. 7B) as a constant current (CC) interval.

However, as the charging continues, the charging voltage of the battery 220 may not increase anymore. Thereafter, as a constant voltage (CV) interval, the charging of the battery 220 may be performed such that the charging current is gradually reduced with the lapse of the charging time.

When a magnitude of the charging current of the battery 220 is less than a magnitude of an EoC current, the controller 250 of the electronic device 100 may terminate the charging of the battery 220.

For example, when the temperature of the battery 220 is Ta that is a value (greater than T1 and less than or equal to T2) of the first temperature range of FIG. 6, the controller 250 may determine the EoC current to be Eoc1. As shown in the solid-line graph of FIG. 7B, the charging current of the battery 220 may decrease to reach EoC1 in the CV interval as the charging time elapses. The controller 250 may terminate the charging of the battery 220 at a point in time ta at which the charging current reaches EoC1.

When the temperature of the battery 220 corresponds to Tb that is a value (greater than T2 and less than or equal to T3) of the second temperature range of FIG. 6, the controller 250 may determine the EoC current to be EoC2 greater than EoC1.

In this case, as shown in the dashed-line graph of FIG. 7B, the charging current of the battery 220 may be gradually reduced in the CV interval as the charging time elapses. The controller 250 may terminate the charging of the battery 220 at a point in time tb' at which the charging current reaches EoC2.

As a comparative example, when the electronic device 100 performs charging at a constant EoC current (e.g., EoC1) irrespective of the temperature of the battery 220, the charging of the battery 220 having the temperature corresponding to Tb may be performed until a point in time tb at which the charging current reaches EoC1, and then terminated.

According to example embodiments of the present disclosure, the electronic device 100 may set an EoC current corresponding to a temperature of the battery 220, thereby preventing an overcharging of the battery 220 and minimizing a cell damage of the battery 220.

For example, when the battery 220 is charged under a high-temperature condition, a swelling phenomenon may easily occur in the battery 220 as the charging is repeated. Also, when the battery 220 is repetitively charged in an overcharged state caused by an EoC current set to be excessively high, the swelling phenomenon may easily occur as compared to a case in which the charging is terminated at a predetermined level of EoC current.

In example embodiments of the present disclosure, when a battery is to be charged at a high temperature, an EoC current may be lowered to prevent an overcharging and minimize a battery swelling. Through this, a battery life may be maximized and a safety and a reliability of an electronic device may be improved.

Although exemplary embodiments of the present disclosure have been described for illustrative purposes, those skilled in the art will appreciate that various modifications, additions, and substitutions are possible within the scope of the appended claims. Therefore, exemplary embodiments of the present disclosure have been described for the sake of brevity and clarity. Accordingly, those skilled in the art will understand the scope of the disclosure is not limited by the explicitly described above embodiments but by the claims.

## Claims

1. An electronic device (100) comprising:
a battery (220);
a charging module (210);
at least one sensor (230, 240); and
a controller (180, 250),
wherein the controller (180, 250) is configured to:
acquire state information of the battery (220) using the at least one sensor (230, 240), the state information of the battery (220) comprising a temperature of the battery (220);
**characterized in that** the controller (180, 250) is configured to:
suspend charging of the battery (220) when the temperature of the battery is out of a predetermined range, wherein the predetermined range is equal to or greater than a first reference temperature value and equal to or less than a second reference temperature value, and
in a case in which the temperature of the battery (220) is within the predetermined range:
divide the temperature range into a predetermined number of sections based on a preset criterion,
set an end of charge, EoC, current for each section,
determine the end of charge EoC, current corresponding to the section including the temperature of the battery (220) to be the EoC current of the battery (220); and
control the charging module to charge the battery (220) based on the determined EoC current.

2. The electronic device (100) of claim 1, wherein, in the case in which the temperature of the battery (220) is within the predetermined range, the controller (180, 250) is configured to:
determine the EoC current of the battery (220) to be a first current value when the temperature of the battery (220) is less than or equal to a first designated value; and
determine the EoC current of the battery (220) to be a second current value greater than the first current value when the temperature of the battery (220) is greater than the first designated value.

3. The electronic device (100) of claim 2, wherein, in the case in which the temperature of the battery (220) is within the predetermined range, the controller (180, 250) is configured to:
determine the EoC current of the battery (220) to be the second current value when the temperature of the battery (220) is greater than the first designated value and less than or equal to a second designated value; and
determine the EoC current of the battery (220) to be a third current value greater than the second current value when the temperature of the battery (220) is greater than the second designated value.

4. The electronic device (100) of claim 1, wherein the controller (180, 250) is configured to:
detect a magnitude of a current supplied to the battery (220) using the at least one sensor (230, 240); and
control the charging module to terminate charging of the battery (220) when the magnitude of the current supplied to the battery (220) is less than or equal to the EoC current.

5. The electronic device (100) of claim 1, wherein the controller (180, 250) is configured to:
periodically update the state information of the battery (220) using the at least one sensor (230, 240); and
re-determine a charging condition of the battery (220) based on the updated state information of the battery (220).

6. The electronic device of claim 1, wherein the controller is set to:
determine the EoC current of the battery to be a first current value when a temperature of the battery corresponds to a first temperature section; and
determine the EoC current of the battery to be a second current value greater than the first current value when the temperature of the battery corresponds to a second temperature section higher than the first temperature section.

7. The electronic device (100) of claim 1, wherein the at least one sensor (230, 240) comprises a current sensor (240).

8. The electronic device (100) of claim 1, wherein the controller (180, 250) is set to charge the battery (220) using a wireless charging module or a wired charging module included in the charging module.

9. A charging control method of an electronic device (100), the method comprising the following steps performed by a controller (180, 250) of the electronic device (100):
acquiring state information of a battery (220) using at least one sensor (230, 240), the state information of the battery (220) comprising a temperature of the battery (220);
**characterized in that** the charging control method further comprises:
suspending charging of the battery (220) when the temperature of the battery (220) is out of a predetermined range, wherein the predetermined range is equal to or greater than a first reference temperature value and equal to or less than a second reference temperature value, and
in a case in which the temperature of the battery (220) is within the predetermined range:
dividing the temperature range into a predetermined number of sections based on a preset criterion,
setting an end of charge, EoC, current for each section,
determining the end of charge, EoC, current corresponding to the section including the temperature of the battery (220) to be the EoC current of the battery (220); and
charging the battery (220) based on the determined EoC current.

10. The charging control method of claim 9, wherein the determining of the EoC comprises:
determining the EoC current of the battery (220) to be a first current value when a temperature of the battery (220) corresponds to a first temperature section; and
determining the EoC current of the battery (220) to be a second current value greater than the first current value when the temperature of the battery (220) corresponds to a second temperature section higher than the first temperature section.

11. The charging control method of claim 9, further comprising:
terminating charging of the battery (220) when a magnitude of a current supplied to the battery (220) reaches the determined EoC current,
wherein the state information of the battery (220) further includes the magnitude of the current supplied to the battery (220).

## Patentansprüche

1. Elektronische Vorrichtung (100), die aufweist:
eine Batterie (220);
ein Lademodul (210);
mindestens einen Sensor (230, 240); und
eine Steuerung (180, 250),
wobei die Steuerung (180, 250) konfiguriert ist, um:
Zustandsinformationen der Batterie (220) unter Verwendung des mindestens einen Sensors (230, 240) zu erhalten, wobei die Zustandsinformationen der Batterie (220) eine Temperatur der Batterie (220) umfassen;
**dadurch gekennzeichnet, dass** die Steuerung (180, 250) konfiguriert ist, um:
ein Laden der Batterie (220) auszusetzen, wenn die Temperatur der Batterie außerhalb eines vorbestimmten Bereichs liegt, wobei der vorbestimmte Bereich gleich oder größer als ein erster Referenztemperaturwert und gleich oder kleiner als ein zweiter Referenztemperaturwert ist, und
in einem Fall, in dem die Temperatur der Batterie (220) innerhalb des vorbestimmten Bereichs liegt:
den Temperaturbereich auf der Grundlage eines vorgegebenen Kriteriums in eine vorbestimmte Anzahl von Abschnitten zu unterteilen,
einen Ladeschluss, EoC, -Strom für jeden Abschnitt festzulegen,
den Ladeschluss, EoC, -Strom der dem Abschnitt mit der Temperatur der Batterie (220) entspricht, als EoC-Strom der Batterie (220) zu ermitteln; und
das Lademodul zu steuern, die Batterie (220) auf der Grundlage des ermittelten EoC-Stroms zu laden.

2. Elektronische Vorrichtung (100) nach Anspruch 1, wobei in dem Fall, in dem die Temperatur der Batterie (220) innerhalb des vorbestimmten Bereichs liegt, die Steuerung (180, 250) konfiguriert ist, um:
den EoC-Strom der Batterie (220) als einen ersten Stromwert zu bestimmen, wenn die Temperatur der Batterie (220) kleiner als oder gleich einem ersten festgelegten Wert ist; und
den EoC-Strom der Batterie (220) als einen zweiten Stromwert zu bestimmen, der größer als der erste Stromwert ist, wenn die Temperatur der Batterie (220) größer als der erste festgelegte Wert ist.

3. Elektronische Vorrichtung (100) nach Anspruch 2, wobei in dem Fall, in dem die Temperatur der Batterie (220) innerhalb des vorbestimmten Bereichs liegt, die Steuerung (180, 250) konfiguriert ist, um:
den EoC-Strom der Batterie (220) als den zweiten Stromwert zu bestimmen, wenn die Temperatur der Batterie (220) größer als der erste bestimmte Wert und kleiner oder gleich einem zweiten bestimmten Wert ist; und
den EoC-Strom der Batterie (220) als einen dritten Stromwert zu bestimmen, der größer als der zweite Stromwert ist, wenn die Temperatur der Batterie (220) größer als der zweite festgelegte Wert ist.

4. Elektronische Vorrichtung (100) nach Anspruch 1, wobei die Steuerung (180, 250) konfiguriert ist, um:
eine Größe eines der Batterie (220) zugeführten Stroms unter Verwendung des mindestens einen Sensors (230, 240) zu erfassen; und
das Lademodul zu steuern, den Ladevorgang der Batterie (220) zu beenden, wenn die Größe des der Batterie (220) zugeführten Stroms kleiner oder gleich dem EoC-Strom ist.

5. Elektronische Vorrichtung (100) nach Anspruch 1, wobei die Steuerung (180, 250) konfiguriert ist, um:
die Zustandsinformationen der Batterie (220) unter Verwendung des mindestens einen Sensors (230, 240) periodisch zu atkualisieren; und
einen Ladezustands der Batterie (220) auf der Grundlage der aktualisierten Zustandsinformationen der Batterie (220) erneut zu bestimmen.

6. Elektronische Vorrichtung nach Anspruch 1, wobei die Steuerung eingestellt ist, um:
den EoC-Strom der Batterie als einen ersten Stromwert zu bestimmen, wenn eine Temperatur der Batterie einem ersten Temperaturbereich entspricht; und
den EoC-Strom der Batterie als einen zweiten Stromwert zu bestimmen, der größer als der erste Stromwert ist, wenn die Temperatur der Batterie einem zweiten Temperaturabschnitt entspricht, der höher als der erste Temperaturabschnitt ist.

7. Elektronische Vorrichtung (100) nach Anspruch 1, wobei der mindestens eine Sensor (230, 240) einen Stromsensor (240) umfasst.

8. Elektronische Vorrichtung (100) nach Anspruch 1, wobei die Steuerung (180, 250) eingestellt ist, die Batterie (220) unter Verwendung eines drahtlosen Lademoduls oder eines in dem Lademodul enthaltenen kabelgebundenen Lademoduls aufzuladen.

9. Ladesteuerungsverfahren eines elektronischen Geräts (100), wobei das Verfahren die folgenden Schritte umfasst, die von einer Steuerung (180, 250) des elektronischen Geräts (100) durchgeführt werden:
Erfassen von Zustandsinformationen einer Batterie (220) unter Verwendung mindestens eines Sensors (230, 240), wobei die Zustandsinformationen der Batterie (220) eine Temperatur der Batterie (220) umfassen;
**dadurch gekennzeichnet, dass** das Ladesteuerungsverfahren ferner umfasst:
Aussetzen eines Ladens der Batterie (220), wenn die Temperatur der Batterie (220) außerhalb eines vorbestimmten Bereichs liegt, wobei der vorbestimmte Bereich gleich oder größer als ein erster Referenztemperaturwert und gleich oder kleiner als ein zweiter Referenztemperaturwert ist, und
in einem Fall, in dem die Temperatur der Batterie (220) innerhalb des vorgegebenen Bereichs liegt:
Unterteilen des Temperaturbereichs in eine vorgegebene Anzahl von Abschnitten auf der Grundlage eines vorgegebenen Kriteriums,
Einstellen eines Ladeschluss, EoC, -Stroms für jeden Abschnitt,
Bestimmen des End-of-Charge, EoC, -Stroms, der dem Abschnitt mit der Temperatur der Batterie (220) entspricht, als EoC-Strom der Batterie (220); und
Laden der Batterie (220) auf der Grundlage des bestimmten EoC-Stroms.

10. Ladesteuerungsverfahren nach Anspruch 9, wobei das Bestimmen des EoC-Stroms umfasst:
Bestimmen des EoC-Stroms der Batterie (220) als einen ersten Stromwert, wenn eine Temperatur der Batterie (220) einem ersten Temperaturabschnitt entspricht; und
Bestimmen des EoC-Stroms der Batterie (220) als einen zweiten Stromwert, der größer als der erste Stromwert ist, wenn die Temperatur der Batterie (220) einem zweiten Temperaturabschnitt entspricht, der höher als der erste Temperaturabschnitt ist.

11. Ladesteuerungsverfahren nach Anspruch 9, das ferner umfasst:
Beenden des Ladens der Batterie (220), wenn eine Größe eines der Batterie (220) zugeführten Stroms den bestimmten EoC-Strom erreicht,
wobei die Zustandsinformation der Batterie (220) ferner die Größe des der Batterie (220) zugeführten Stroms umfasst.

## Revendications

1. Dispositif électronique (100) comprenant:
une batterie (220);
un module de charge (210);
au moins un capteur (230, 240); et
un organe de commande (180, 250),
dans lequel l'organe de commande (180, 250) est conçu pour:
acquérir des informations sur l'état de la batterie (220) à l'aide d'au moins un capteur (230, 240), les informations sur l'état de la batterie (220) comprenant une température de la batterie (220);
**caractérisé en ce que** l'organe de commande (180, 250) est conçu pour:
suspendre la charge de la batterie (220) lorsque la température de la batterie est en dehors d'une plage prédéterminée, la plage prédéterminée étant supérieure ou égale à une première valeur de température de référence et inférieure ou égale à une deuxième valeur de température de référence, et
dans le cas où la température de la batterie (220) se situe dans la plage prédéterminée:
diviser la plage de température en un nombre prédéterminé de sections sur la base d'un critère prédéfini,
définir un courant de fin de charge, EoC, pour chaque section,
déterminer le courant de fin de charge, EoC, correspondant à la section incluant la température de la batterie (220) comme étant le courant EoC de la batterie (220); et
amener le module de charge à charger la batterie (220) sur la base du courant EoC déterminé.

2. Dispositif électronique (100) selon la revendication 1, dans lequel, dans le cas où la température de la batterie (220) se situe dans la plage prédéterminée, l'organe de commande (180, 250) est conçu pour:
déterminer que le courant EoC de la batterie (220) est une première valeur de courant lorsque la température de la batterie (220) est inférieure ou égale à une première valeur désignée; et
déterminer que le courant EoC de la batterie (220) est une deuxième valeur de courant supérieure à la première valeur de courant lorsque la température de la batterie (220) est supérieure à la première valeur désignée.

3. Dispositif électronique (100) selon la revendication 2, dans lequel, dans le cas où la température de la batterie (220) se situe dans la plage prédéterminée, l'organe de commande (180, 250) est conçu pour:
déterminer que le courant EoC de la batterie (220) est une deuxième valeur de courant lorsque la température de la batterie (220) est supérieure à une première valeur désignée et inférieure ou égale à une seconde valeur désignée; et
déterminer que le courant EoC de la batterie (220) est une troisième valeur de courant supérieure à la deuxième valeur de courant lorsque la température de la batterie (220) est supérieure à la deuxième valeur désignée.

4. Dispositif d'affichage (100) selon la revendication 1, dans lequel l'organe de commande (180) est en outre conçu pour:
détecter une amplitude d'un courant fourni à la batterie (220) à l'aide de l'au moins un capteur (230, 240); et
amener le module de charge à arrêter la charge de la batterie (220) lorsque l'amplitude du courant fourni à la batterie (220) est inférieure ou égale au courant EoC.

5. Dispositif d'affichage (100) selon la revendication 1, dans lequel l'organe de commande (180) est en outre conçu pour:
Mettre à jour périodiquement les informations sur l'état de la batterie (220) à l'aide de l'au moins un capteur (230, 240); et
déterminer à nouveau un état de charge de la batterie (220) en fonction des informations sur l'état de batterie de la batterie (220).

6. Dispositif électronique (100) selon la revendication 1, dans lequel l'organe de commande est défini pour:
déterminer que le courant EoC de la batterie est une première valeur de courant lorsque la température de la batterie correspond à la première section de température; et
déterminer que le courant EoC de la batterie est une deuxième valeur de courant supérieure à la première valeur de courant lorsque la température de la batterie correspond à une seconde section de température supérieure à la première section de température.

7. Dispositif électronique (100) selon la revendication 1, dans lequel l'au moins un capteur (230, 240) comprend un capteur de courant (240).

8. Dispositif électronique (100) selon la revendication 1, dans lequel l'organe de commande (180, 250) est défini pour charger la batterie (220) à l'aide d'un module de charge sans fil ou un module de charge filaire inclus dans le module de charge.

9. Procédé de commande de charge d'un dispositif électronique (100), le procédé comprenant les étapes suivantes réalisées par un organe de commande (180, 250) du dispositif électronique (100):
acquérir des informations sur l'état d'une batterie (220) à l'aide d'au moins un capteur (230, 240), les informations sur l'état de la batterie (220) comprenant une température de la batterie (220);
**caractérisé en ce que** le procédé de commande de charge consiste en outre à:
suspendre la charge de la batterie (220) lorsque la température de la batterie est en dehors d'une plage prédéterminée, la plage prédéterminée étant supérieure ou égale à une première valeur de température de référence et inférieure ou égale à une deuxième valeur de température de référence, et
dans le cas où la température de la batterie (220) se situe dans la plage prédéterminée:
diviser la plage de température en un nombre prédéterminé de sections sur la base d'un critère prédéfini,
définir un courant de fin de charge, EoC, pour chaque section,
déterminer le courant de fin de charge, EoC, correspondant à la section incluant la température de la batterie (220) comme étant le courant EoC de la batterie (220); et
charger la batterie (220) sur la base du courant EoC déterminé.

10. Procédé de commande de charge selon la revendication 9, dans lequel la détermination de l'EoC comprend:
la détermination du fait que le courant EoC de la batterie (220) est une première valeur de courant lorsque la température de la batterie (220) correspond à une première section de température; et
la détermination du fait que le courant EoC de la batterie (220) est une deuxième valeur de courant supérieure à la première valeur de courant lorsque la température de la batterie (220) correspond à une seconde section de température supérieure à la première section de température.

11. Procédé de commande de charge selon la revendication 9, comprenant en outre:
la fin de la charge de la batterie (220) lorsqu'une amplitude d'un courant fourni à la batterie (220) atteint le courant EoC déterminé,
dans lequel les informations sur l'état de la batterie (220) comprennent en outre l'amplitude du courant fourni à la batterie (220).
